# EUROPÄISCHE PATENTSCHRIFT

(11) **EP 0 532 941 B1**
(45) Veröffentlichungstag und Bekanntmachung des Hinweises auf die Patenterteilung: **09.08.1995**
(21) Anmeldenummer: 92114397.0
(22) Anmeldetag: 24.08.1992
(51) Int. Cl.: H01L 29/10

(54) **Thyristor mit Randstruktur**
Thyristor with edge structure
Thyristor avec une structure périphérique

(30) Priorität: 20.09.1991 DE 4131376
(43) Veröffentlichungstag der Anmeldung: 24.03.1993
(73) Patentinhaber: EUPEC Europäische Gesellschaft für Leistungshalbleiter mbH & Co. KG, D-59581 Warstein (DE)
(72) Erfinder: Voss, Peter, Dr., W-8000 München 81 (DE); Ziegler, Elmar, Dr., W-8051 Langenbach (DE); Loch, Karl-Heinz, W-8553 Ebermannstadt (DE); Schmidt, Gerhard, Dr., W-8550 Forchheim (DE)
(74) Vertreter: Fuchs, Franz-Josef, Dr.-Ing.

(56) Entgegenhaltungen:
- EP-A- 0 039 509
- EP-A- 0 283 788
- EP-A- 0 303 046

## Beschreibung

Die Erfindung bezieht sich auf einen Thyristor mit einem Halbleiterkörper mit mindestens vier aneinandergrenzenden Zonen abwechselnden Leitungstyps, von denen einer eine katodenseitige Basiszone ist, die einen unter einem negativen Winkel abgeschrägten Randbereich mit einem ersten Dotierungsgradienten und einer ersten Dotierungskonzentration und einen zentralen Bereich mit einem zweiten, höheren Dotierungsgradienten und einer zweiten, höheren Dotierungskonzentration an der katodenseitigen Oberfläche hat.

Ein solcher Thyristor ist z.B. in der EP 0 039 509 A2 beschrieben worden. Die unterschiedlichen Dotierungsgradienten und die unterschiedlichen Dotierungen des zentralen Bereichs sind offensichtlich derart gewählt, daß sich die Raumladungszone an der katodenseitigen Oberfläche bei Belastung in Blockierrichtung vom Randbereich bis in den stark dotierten zentralen Bereich der katodenseitigen Basiszone ausdehnt. Damit wird die Sperrspannung in Blockierrichtung herabgesetzt.

In der europäischen Patentanmeldung 0 303 046 A1 ist ein ähnlicher Thyristor beschrieben. Bei diesem hat der Randbereich neben der zweiten, niedrigeren Dotierung und dem zweiten, niedrigeren Dotierungsgradienten an der Oberseite auch noch eine Schicht mit der ersten, höheren Dotierungskonzentration und dem ersten, höheren Dotierungsgradienten.

Der Erfindung liegt die Aufgabe zugrunde, einen Thyristor der beschriebenen Gattung so weiterzubilden, daß eine hohe Sperrspannung in Vorwärtsrichtung auch dann erreicht wird, wenn der zentrale Bereich zumindest in einem Teil des im Blockierfall von der Raumladungszone erfaßten Gebiets hoch dotiert ist.

Diese Aufgabe wird dadurch gelöst, daß der Randbereich ausschließlich den ersten Dotierungsgradienten und die erste Dotierungskonzentration hat, daß der Randbereich unter einem Winkel von 1 bis 10° abgeschrägt ist, daß die Gesamtdotierung im Randbereich am Übergang zum zentralen Bereich der katodenseitigen Basiszone höher als 1,5 x 10¹² Atome/cm² beträgt und so gewählt ist, daß die katodenseitige Begrenzung der Raumladungszone im Randbereich an die Oberfläche des Halbleiterkörpers stößt.

Weiterbildungen der Erfindung sind Gegenstand der Unteransprüche

Die Erfindung wird anhand einiger Ausführungsbeispiele in Verbindung mit den Figuren 1 bis 5 näher erläutert. Es zeigen
- Figur 1: den Schnitt durch einen Halbleiterkörper eines Thyristors gemäß einem ersten Ausführungsbeispiel und
- Figur 2 bis 5: den teilweisen Schnitt durch charakteristische Bereiche des Halbleiterkörpers von Thyristoren gemäß weiteren Ausführungsbeispielen.

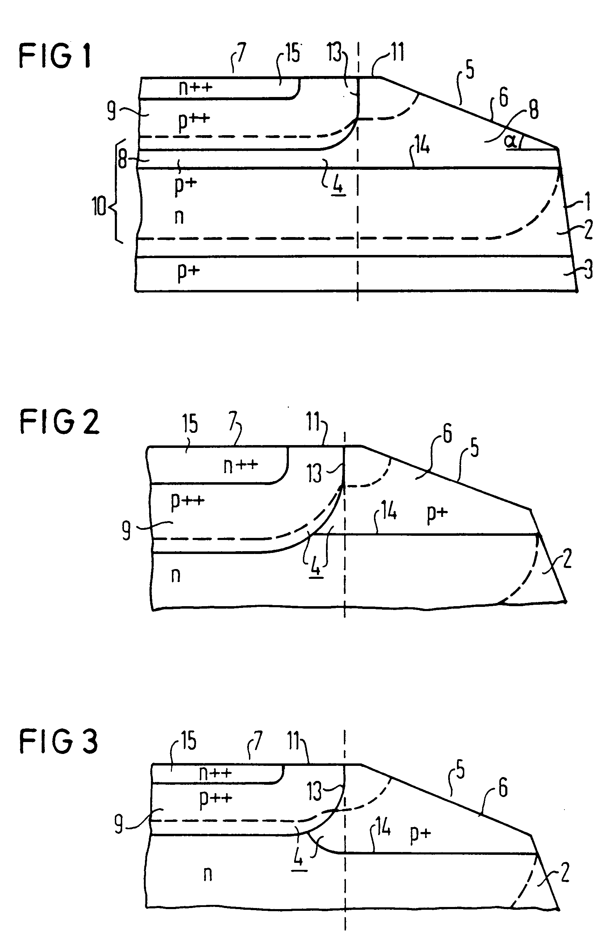

Der Thyristor nach Figur 1 hat einen Halbleiterkörper 1 mit einer n-dotierten Mittelzone 2 und einer p-dotierten Anodenemitterzone 3. Katodenseitig schließt sich an die Mittelzone 2 eine Katodenbasiszone 4 an, die sich aus den Schichten 8 und 9 zusammensetzt. Zwischen der Katodenbasiszone 4 und der Mittelzone 2 liegt ein pn-Übergang 14. Die Katodenbasiszone 4 hat einen Randbereich 5 und einen zentralen Bereich 7. Der Randbereich 5 ist dadurch charakterisiert, daß er niedrig dotiert ist und eine unter einem Winkel α bezüglich der Hauptflächen des Thyristors abgeschrägte Flanke 6 enthält. Der Winkel α ist kleiner als 10 Grad und beträgt im allgemeinen zwischen ein und vier Grad. Der zentrale Bereich 7 enthält die sich an den pn-Übergang 14 anschließende niedrig dotierte Schicht 8 und eine sich an die Schicht 8 anschließende hochdotierte Schicht 9. In die Schicht 9 ist eine Katodenzone 15 eingebettet. Die katodenseitige Oberfläche des Halbleiterkörpers ist mit 11 bezeichnet. Zwischen dem p⁺⁺-dotierten zentralen Bereich 9 und der p⁺-dotierten Schicht 8 liegt ein Übergang 13.

Der zentrale Bereich 7 der Katodenbasiszone 4 weist eine höhere Flächendotierung als der Randbereich 5 auf, um z. B. im Hinblick auf die du/dt-Festigkeit des Thyristors eine bestimmte hohe Querleitfähigkeit unter dem n-Emitter einstellen zu können. Im Randbereich 5 wird hingegen das Einstellen der Sperrfähigkeit umso einfacher beherrscht, je geringer sein Dotierungsgradient ist, d. h. je geringer seine Dotierung eingestellt wird.

Die Dotierung darf allerdings auch nicht zu gering werden, weil das Randgebiet sonst nicht mehr in der Lage ist, die Raumladungszone aufzufangen. Um ein Hineinlaufen der Raumladungszone entlang der Oberfläche in den zentralen Bereich hinein zu verhindern, muß der Randbereich in dem an den zentralen Bereich angrenzenden Gebiet mindestens mit 1,5 x 10¹² Atomen cm⁻² dotiert sein.

Typische Werte für solche Thyristoren sind: die Dotierung des Randbereichs der oberen Grenze der Raumladungszone 10 ist 5 x 10¹⁴- 2 x 10¹⁵cm⁻³; pn-Übergangstiefe 60 bis 100 »m gemessen von der katodenseitigen Oberfläche 11; Oberflächendotierung der Katodenbasiszone 4 an der Oberfläche 11 l x 10¹⁸cm⁻³, Eindringtiefe der Basiszone 4 ist 30 bis 70 »m.

Im Ausführungsbeispiel nach Figur 1 hat der zentrale Bereich 7 und der Randbereich 5 der Katodenbasiszone 4 die gleiche Tiefe. In Figur 2 ist eine Anordnung dargestellt, in der der Randbereich 5 gemessen von der Oberfläche 11 eine kleinere Eindringtiefe als der zentrale Bereich 7 hat. Es ist auch der umgekehrte Fall möglich, bei dem der Randbereich 5 eine größere Tiefe als der zentrale Bereich 7 hat (Figur 3).

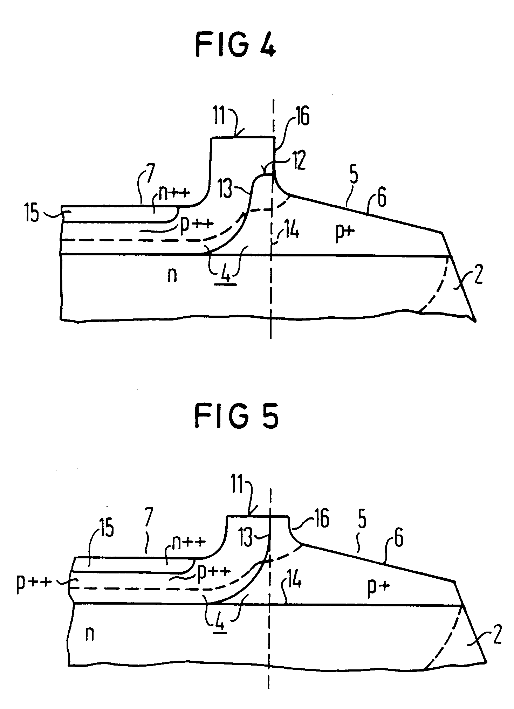

In den Figuren 4 und 5 sind zwei Ausführungsbeispiele dargestellt, bei denen der Halbleiterkörper vor der Herstellung des zentralen Bereichs 7 strukturiert wurde. Bei beiden Ausführungsbeispielen wurde der Halbleiterkörper im zentralen Bereich der Katodenbasiszone mit einer Vertiefung versehen. Beim Ausführungsbeispiel nach Figur 4 wird nach der Herstellung einer p⁺-dotierten Schicht, die über die ganze Fläche des Halbleiterkörpers reicht, die Katodenseite strukturiert und die gesamte katodenseitige Oberfläche mit Dotiermaterial belegt, das anschließend in einem Diffusionsschritt eindiffundiert wird. Anschließend wird dann die stark p-dotierte Schicht im Randbereich 5 entfernt, so daß der p⁺⁺-p⁺-Übergang 13 etwa waagrecht an die Oberfläche tritt.

Im Ausführungsbeispiel nach Figur 5 wird nur der zentrale Bereich mit dem Dotierstoff für die p⁺⁺-Dotierung belegt. Der p⁺⁺-p⁺-Übergang 13 tritt hier senkrecht an die Oberfläche 11.

Als zusätzliche Maßnahme kann auch in den Ausführungsbeispielen nach Figur 1 bis 3 - gezeigt ist sie nur in den Figuren 4 und 5 - zwischen der katodenseitigen Oberfläche 11 und der abgeschrägten Flanke 6 eine Stufe 16 liegen. Damit können die lateralen Abmessungen des Randbereichs 5 verkleinert werden. Die lateralen Abmessungen werden dabei so festgelegt, daß die obere Grenze der Raumladungszone 10 nicht in den Radius zwischen Stufe 16 und Flanke 6 hineinläuft. Umgekehrt kann das Beispiel nach Figur 5 auch ohne Stufe ausgeführt werden.

## Patentansprüche

1. Thyristor mit einem Halbleiterkörper mit mindestens vier aneinandergrenzenden Zonen abwechselnden Leitungstyps, von denen einer eine katodenseitige Basiszone (4) ist, die einen unter einem negativen Winkel abgeschrägten Randbereich (5) mit einem ersten Dotierungsgradienten und einer ersten Dotierungskonzentration und einen zentralen Bereich (7) mit einem zweiten, höheren Dotierungsgradienten und einer zweiten, höheren Dotierungskonzentration an der katodenseitigen Oberfläche hat,
**dadurch gekennzeichnet,** daß der Randbereich (5) ausschließlich den ersten Dotierungsgradienten und die erste Dotierungskonzentration hat, daß der Randbereich (5) unter einem Winkel von 1 bis 10° abgeschrägt ist, daß die Gesamtdotierung im Randbereich (5) am Übergang zum zentralen Bereich (7) der katodenseitigen Basiszone (4) höher als 1,5 x 10¹² Atome/cm² beträgt und so gewählt ist, daß bei Sperrbelastung die katodenseitige Begrenzung der Raumladungszone (10) im Randbereich (5) an die Oberfläche des Halbleiterkörpers stößt.

2. Thyristor nach Anspruch 1,
**dadurch gekennzeichnet,** daß die katodenseitige Basiszone (4) im zentralen Bereich (7) aus einer stark dotierten Schicht (9) und einer darunterliegenden schwächer dotierten Schicht (8) besteht, und daß die katodenseitige Basiszone im Randbereich (5) aus der schwächer dotierten Schicht besteht.

3. Thyristor nach Anspruch 1,
**dadurch gekennzeichnet,** daß der Randbereich (5) der Katodenseitigen Basiszone (4) eine geringere Eindringtiefe als der zentrale Bereich (7) hat.

4. Thyristor nach Anspruch 1,
**dadurch gekennzeichnet,** daß der Randbereich (5) der Katodenseitigen Basiszone (4) die gleiche Eindringtiefe wie der zentrale Bereich (7) hat.

5. Thyristor nach Anspruch 1,
**dadurch gekennzeichnet,** daß der Randbereich (5) der Katodenseitigen Basiszone (4) eine größere Eindringtiefe als der zentrale Bereich (7) hat.

6. Thyristor nach einem der Ansprüche 1 bis 5,
**dadurch gekennzeichnet,** daß zwischen der katodenseitigen Oberfläche (11) des Halbleiterkörpers und dem Randbereich (5) eine Stufe (16) liegt.

## Claims

1. Thyristor having a semiconductor body having at least four adjoining regions of alternating conduction type, one of which is a cathode-side base region (4) having at the cathode-side surface an edge region (5), which is bevelled at a negative angle and has a first doping gradient and a first doping concentration, and a central region (7), which has a second, higher doping gradient and a second, higher doping concentration, characterized in that the edge region (5) has exclusively the first doping gradient and the first doping concentration, in that the edge region (5) is bevelled at an angle of 1 to 10°, in that the total doping in the edge region (5) at the junction with the central region (7) of the cathode-side base region (4) is higher than 1.5 × 10¹² atoms/cm² and is chosen such that in the event of a blocking load the cathode-side boundary of the space charge region (10) in the edge region (5) abuts the surface of the semiconductor body.

2. Thyristor according to Claim 1, characterized in that the central region (7) of the cathode-side base region (4) comprises a strongly doped layer (9) and a more weakly doped layer (8) beneath the latter, and in that the edge region (5) of the cathode-side base region comprises the more weakly doped layer.

3. Thyristor according to Claim 1, characterized in that the edge region (5) of the cathode-side base region (4) has a smaller penetration depth than the central region (7).

4. Thyristor according to Claim 1, characterized in that the edge region (5) of the cathode-side base region (4) has the same penetration depth as the central region (7).

5. Thyristor according to Claim 1, characterized in that the edge region (5) of the cathode-side base region (4) has a larger penetration depth than the central region (7).

6. Thyristor according to one of Claims 1 to 5, characterized in that there is a step (16) between the cathode-side surface (11) of the semiconductor body and the edge region (5).

## Revendications

1. Thyristor ayant un corps semiconducteur comportant au moins quatre zones attenantes les unes aux autres et de types de conduction alternés, parmi lesquelles l'une est une zone (4) de base du côté cathode, qui a une région (5) de bord inclinée d'un angle négatif ayant un premier gradient de dopage et ayant une première concentration de dopage, et une région (7) centrale ayant un deuxième gradient plus grand de dopage et une deuxième concentration de dopage plus grande à la surface du côté cathode,
caractérisé en ce que la région (5) de bord a exclusivement le premier gradient de dopage et la première concentration de dopage, la région (5) de bord est inclinée d'un angle de 1 à 10°, le dopage total dans la région (5) de bord à la jonction vers la région centrale (7) de la zone (4) de base du côté cathode est plus grand que 1,5 x 10¹² atomes/cm² et est choisi de sorte que la limite, du côté cathode, de la zone (10) de charge d'espace dans la région (5) de bord rencontre, à l'état bloqué, la surface du corps semiconducteur.

2. Thyristor suivant la revendication 1,
caractérisé en ce que la zone (4) de base côté cathode dans la région (7) centrale est constituée d'une couche (9) à fort dopage et d'une couche (8) se trouvant en-dessous et à petit dopage, et la zone de base du côté cathode dans la région (5) de bord est constituée de la couche de petit dopage.

3. Thyristor suivant la revendication 1,
caractérisé en ce que la zone (5) de bord de la zone (4) de base du côté cathode a une profondeur de pénétration plus petite que la région (7) centrale.

4. Thyristor suivant la revendication 1,
caractérisé en ce que la zone (5) de bord de la zone (4) de base du côté cathode a la même profondeur de pénétration que la région (7) centrale.

5. Thyristor suivant la revendication 1, caractérisé en ce que la région (5) de bord de la zone (4) de base du côté cathode a une plus grande profondeur de pénétration que la région (7) centrale.

6. Thyristor suivant l'une des revendications 1 à 5, caractérisé en ce qu'une marche (16) se trouve entre la surface (11) du côté cathode du corps semiconducteur et la région (5) de bord.
